# EUROPEAN PATENT SPECIFICATION

(11) **EP 3 807 227 B1**
(45) Date of publication and mention of the grant of the patent: **16.10.2024**
(21) Application number: 19729321.0
(22) Date of filing: 13.06.2019
(51) Int. Cl.: C03C 23/00, G02B 5/00

(54) **REFLECTANCE REDUCTION OF SUBSTRATE FOR TRANSMITTING INFRARED LIGHT**
REFLEXIONSVERMINDERUNG EINES SUBSTRATS ZUR ÜBERTRAGUNG VON INFRAROTLICHT
RÉDUCTION DE RÉFLECTANCE DE SUBSTRAT POUR TRANSMETTRE UNE LUMIÈRE INFRAROUGE

(30) Priority: 14.06.2018 EP 18177799
(43) Date of publication of application: 21.04.2021
(73) Proprietor: AGC Glass Europe, 1348 Louvain-La-Neuve (BE); AGC Inc., Chiyoda-ku Tokyo 100-8405 (JP); AGC Flat Glass North America, Inc., Alpharetta, 30022-1167 (US); AGC Vidros do Brasil Ltda, 12523-671 São Paulo, Guaratinguetá (BR)
(72) Inventor: NAVET, Benjamine, 1348 Louvain-La-Neuve (BE); JACQUES, Amory, 5100 Jambes (BE); ROQUINY, Philippe, 5190 Moustier-sur-Sambre (BE)
(74) Representative: AGC Glass Europe
(86) International application number: PCT/EP2019/065579
(87) International publication number: WO 2019/238868

(56) References cited:
- EP-A1- 0 608 202
- EP-A1- 3 389 078
- EP-A1- 3 428 975
- EP-A2- 0 318 440
- WO-A1-2019/149685
- US-A- 4 262 056
- US-A- 4 590 374
- US-A1- 2016 052 821
- US-A1- 2017 114 442
- DESCHKOWSKAJA A: "VERAENDERUNG DER OBERFLAECHENSCHICHTEN VON GLAESERN DURCH IONENIMPLANTATION//MODIFICATION OF THE SURFACE LAYERS OF GLASSES BY ION IMPLANTATION//MODIFICATION DES COUCHES SUPERFICIELLES DE VERRES SOUMIS A UNE IMPLANTATION IONIQUE", GLASTECHNISCHE BERICHTE, VERLAG DER DEUTSCHEN GLASTECHNISCHEN GESELLSCHAFT, FRANKFURT, DE, vol. 59, no. 11, 1 January 1986 (1986-01-01), pages 326 - 331, XP001221680, ISSN: 0017-1085
- POLATO P ET AL: "CHARACTERIZATION BY NUCLEAR AND SPECTROPHOTOMETRIC ANALYSIS OF NEAR-SURFACE MODIFICATIONS OF GLASS IMPLANTED WITH HEAVY IONS", JOURNAL OF THE AMERICAN CERAMIC SOCIETY, BLACKWELL PUBLISHING, MALDEN, MA, US, vol. 70, no. 10, 1 October 1987 (1987-10-01), pages 775 - 779, XP001221681, ISSN: 0002-7820, DOI: 10.1111/J.1151-2916.1987.TB04878.X

## Description

### Technical Field

The present invention relates to substrates that can act as optical elements for transmitting infrared light and that have low reflectance for infrared light. The substrates of the present invention are suitable for cover glasses and optical elements, such as lenses, prisms, or mirrors to be used with infrared light. In particular the invention relates to the Use of implanted ions implanted into a substrate in order to reduce its reflectance of infrared light and also relates to an assembly of such a substrate with a source of infrared light and/or with an infrared-sensitive optical component.

### Background Art

A variety of applications, ranging from the detection of infrared (IR) signals, for instance in thermal imaging, to element identification in IR spectroscopy, make use of infrared light. A certain range of substrates is being used to manufacture optical elements that transmit, reflect and/or generally control the trajectory of IR light, such as plano-optics (i.e. windows, mirrors, polarizers, beamsplitters, prisms), spherical lenses (i.e. plano-concave/convex, double-concave/convex, meniscus), aspheric lenses (parabolic, hyperbolic, hybrid), achromatic lenses, and lens assemblies (i.e. imaging lenses, beam expanders, eyepieces, objectives). The bulk materials of these substrates for infrared applications vary in their physical, in particular optical, characteristics. As a result, knowing the benefits of each characteristic allows one to select the correct material for any IR application. Since infrared light is comprised of longer wavelengths than visible light, the two wavelength regions, visible and infrared, behave differently when propagating through the same optical medium. In general, certain materials can be used for both IR and visible applications, most notably fused silica, borosilicate glass, sapphire, alumina-silicate glass and certain soda-lime glasses, while others are used only for one or the other application. The foremost attribute defining any bulk material for infrared light is transmittance of infrared light. Transmittance is a measure of throughput and is given as a percentage of the incident light.

Optical elements for infrared light comprise a substrate and may further comprise coatings. Anti-reflection (AR) coatings are frequently used to improve the efficiency of optical elements by increasing transmission of infrared light, enhancing contrast, and eliminating ghost images. These AR coatings generally need to be durable, with resistance to both physical and environmental damage and they range from single layer coatings, of intermediate index between that of air and the substrate, to complex multi-layer stacks of alternating high refractive index and low refractive index layers. The multi-layer stacks, although effective to reduce IR reflectance, they require expensive equipment, generally have lower durability than the substrate itself.

For certain applications, a compromise must be made regarding the wavelength range in which the reflectance can be lowered by common AR coatings. In particular, it is difficult to obtain anti-reflective coatings for infrared radiation, in particular near-infrared light in the range between 800 nm and 3 µm, while maintaining low visible light reflectance and/or reflected light colors that are close to neutral or have a blue-green tint.

EP0318440 discloses a process for the manufacture of glass capable of transmitting and reflecting radiant energy in an amount different from that transmitted and reflected by the original glass. US2017/114442 discloses a treatment method for modifying the reflected colour of a sapphire material surface.

### Summary of invention

The objective of the invention in particular is to remedy one or more of the cited disadvantages, i.e. to provide a substrate, in particular an ion implanted substrate, with lower reflectance in the infrared light range, in particular in the wavelength range between 800 nm and 3 µm, in particular between 800 nm and 2.5 µm and at the same time limit or even avoid increasing the reflectance of light in the visible light wavelength range. The substrate according to the present invention is a substrate for transmitting infrared light.

An additional objective of the present invention, in certain of its embodiments, is to provide an ion implanted substrate for transmitting infrared light with lower reflectance in the infrared light range between 800 nm and 3 µm and with a neutral or blue-green color in reflection.

Another additional objective of the present invention, in certain of its embodiments, is the use of implanted ions implanted into a substrate at certain acceleration voltages and dosages, to reduce the reference reflectance of an a substrate for an optical element in the infrared light range between 800 nm and 3 µm glass sheet. The resulting substrate or optical element has a lower reflectance in the infrared wavelength range from 800 nm to 3 µm, meaning that its reference reflectance in this infrared wavelength range is lower than the reference reflectance of the untreated substrate.

Another additional objective of the invention is to provide an optical assembly for controlling infrared light in the range between 800 nm and 3 µm comprising an ion implanted optical element for transmitting the infrared light having low reflectance in the infrared light range between 800 nm and 3 µm and an infrared sensitive optical component and/or an infrared light source.

According to the present invention one or more of these objectives are obtained by ion implantation, with a mixture of single charge and multicharge ions, of at least part of the surface of the substrate forming the optical element.

The inventors have surprisingly found that implanting substrates with ions of certain atoms at certain acceleration voltages and certain dosages lowers the reflectance of the substrates in the infrared wavelength range from 800 nm to 3µm.

The inventors have also found that implanting substrates with ions of certain atoms at certain acceleration voltages and certain dosages leads to the formation of a bi-layer structure within the substrate, at the substrate surface. The bi-layer comprises, starting from the substrate surface and going towards the core of the substrate, a first layer having the same refractive index as the bulk substrate, and a porous second layer, having a refractive index lower than the bulk substrate. The solid material forming the 1^{st} layer and porous second layer consists essentially of the same material as the substrate bulk.

The present invention also concerns the use of implanted ions implanted into a substrate for reducing the substrate's reflectance of infrared light in the wavelength range from 800nm to 3µm, in particular from 800 nm to 2.5 µm.

It is noted that the invention relates to all possible combinations of features recited in the claims.

### Brief description of drawings

FIG. 1 shows reference reflectance curves in the infrared light range of three exemplary substrates for transmitting infrared light according to the present invention and one non-treated substrate.
FIG. 2 shows a schematic cross-section of a substrate according to the present invention.
FIG. 3 shows reference reflectance curves in the visible and infrared light ranges of three exemplary substrates for transmitting infrared light according to the present invention and for one non-treated substrate and for one ion implanted substrate not according to the present invention.

### Description of embodiments

The invention relates to the use of implanted ions to decrease the infrared reflectance of a substrate for transmitting infrared light, in particular in the wavelength range from 800 nm to 3 µm, where ions are implanted in the substrate.

According to the present invention, the ion implantation comprises the implantation of positively charged ions of N, H, O, He, Ne, Ar or Kr. According the present invention the positively charged implanted ions comprise a mixture of single and multiple charged ions. Advantageously the ion implantation comprises the implantation of positively charged ions of N, H, O, or He as they require lesser acceleration voltages.

Preferred statements (features) and embodiments of uses of this invention and articles comprising this invention are set herein below. Each statement and embodiment of the invention so defined may be combined with any other statement and/or embodiment, unless clearly indicated to the contrary. In particular, any feature indicated as being preferred or advantageous may be combined with any other features or statements indicated as being preferred or advantageous.

According to an embodiment of the present invention the implanted substrate of the present invention comprises no other layers than the bi-layer structure at the implanted surface of the substrate.

It was found that the degree of infrared light reflectance can be varied by varying the amount of ions implanted and their implantation depth.

According to an embodiment of the present invention, the ion dosage is comprised between 10¹⁶ ions/cm² and 2 × 10¹⁷ ions/cm², advantageously between 10¹⁶ ions/cm² and 1.5 × 10¹⁷ ions/cm², more advantageously between 10¹⁶ ions/cm² and 9.5 × 10¹⁶ ions/cm². Within these ranges, the dosage may be at least 2 × 10¹⁶ ions/cm², at least 4 × 10¹⁶ ions/cm² or even at least 6 × 10¹⁶ ions/cm². The ion dosage may for example be controlled by the duration of exposure to the ion beam and also depends on the fluence of the beam.

Implanted ions may be present in the substrate beyond the porous second layer. According to an embodiment of the present invention, no additional porous layer, other than the porous second layer, is present in the substrates of embodiments of the present invention. According to another embodiment of the present invention, one additional porous third layer, is present in a substrate, having a pore density different from the pore density of the porous second layer.

The implantation depth may be controlled by the acceleration voltage of the ion source for a given ion or ion mixture.

Electron Cyclotron Resonance (ECR) ion sources providing an ion beam comprising a mixture of single charged ions and multi charged ions are particularly useful as for a certain acceleration voltage, a double charged ion of a certain species, for example N²⁺, will have double the implantation energy of the corresponding single charge ion, N⁺. Thereby greater implantation depths can be reached without having to increase the acceleration voltage. The inventors have found that ion sources providing an ion beam comprising a mixture of single charge and multicharge ions, accelerated with the same acceleration voltage are particularly useful as they may provide higher fluences than single charge ion beams. They are therefore able to reach a certain dosage in a shorter amount of time. According to the present invention the ECR ion source may provide an ion current of at least 0.5 mA, advantageously at least 0.8 mA, more advantageously at least 1.0 mA and not more than 50mA.

In an embodiment of the present invention the ion beam at least 90% of the ions in the ion beam comprise single charge and double charge ions of a species selected from N, O, He, Ne, Ar, and Kr and the ratio of single charge species and double charge species is at least 55/25. The respective single charge and double charge species are N⁺ and N²⁺, O⁺ and O²⁺, He⁺ and He²⁺, Ne⁺ and Ne²⁺, Ar⁺ and Ar²⁺, Kr⁺ and Kr²⁺. Hydrogen is only available as single charge ion H⁺.

In certain embodiments the substrate being implanted is moved relative to the ion beam in order to treat its entire surface.

According to the present invention the substrate may comprise a flat, sheet-like, substrate or a non-flat substrate, such as a prism or a lens. The substrate may be obtained by casting, cutting, bending, grinding or pressing to obtain the desired shape, before undergoing ion implantation.

Measuring the reflection and comparing reflectance values on optical elements that are not flat is very complicated. Therefore and for the purpose of the present text, the term of 'reference reflectance' is defined and used for all substrates when appropriate. The reference reflectance of a substrate is the reflectance of a 1.6 mm thick flat sheet of the substrate's material, treated by the same ion implantation when appropriate, or comprising the same bi-layer when appropriate. The reference reflection is measured on the surface that has been ion implanted as the percentage of incoming light that is reflected from the surface at an 8° angle. The average reference reflectance is calculated by averaging of the measurement values over the selected wavelength range.

The reference color in reflection is calculated from this measurement and is expressed using CIELAB color coordinates a* and b* under illuminant D65 using 10° observer angle. CIE L*a*b* or CIELAB is a color space specified by the International Commission on Illumination and is routinely used in glass industry among others. Unless specified otherwise, the visible light reference reflectance Rc, and the reference colors in reflection a*_{Rc}, b*_{Rc} are measured at an angle of 8° , close to perpendicular to the substrate surface.

Reflectance is routinely measured using spectrophotometers operating in the appropriate wavelength range. In the examples below measurements were made up to a wavelength of 2.5 µm. Optical simulations show that reflectance values at least up to 3µm wavelength can be extrapolated from these measurements.

Throughout the present text, when a numerical range is indicated, the limits of the range are considered to be included in the range. In addition, all the integral and subdomain values in the numerical range are expressly included as if explicitly written.

Depending on the application it may be relevant to obtain a low infrared (IR) reference reflectance over as much as possible of the IR wavelength range from 800 nm to 3 µm, or it may be relevant to reduce the reference reflectance as much as possible at a certain wavelength *λ* ₘᵢₙ, where *λ* ₘᵢₙ is in the range from 800 nm to 3 µm.

According to an embodiment of the present invention, the reference reflectance of a substrate in the infrared wavelength range, in particular in the wavelength range from 800 nm to 3 µm, is reduced by using an ion implantation process comprising the following operations:
a. providing a source gas selected among N₂, H₂, O₂, He, Ne, Ar, and Kr,
b. ionizing the source gas so as to form ions of N, O, He, Ne, Ar, or Kr, wherein the ions comprise a mixture of single charge and multicharge ions of N, O, He, Ne, Ar, or Kr.
c. accelerating the ions with an acceleration voltage so as to form a beam, wherein the first acceleration voltage is comprised between 5.5 and 450 kV, and
d. positioning a surface of the substrate in the trajectory of the beam so as to obtain an ion dosage comprised between 10¹⁶ ions/cm² and 2 × 10¹⁷ ions/cm².

The inventors have found that the reference reflectance in the infrared wavelength range, in particular between 800nm and 3 µm, may be reduced. In particular the average reference reflectance between 800nm and 3 µm.

The implantation of ions according to the present invention may reduce the average reference reflectance of a substrate, in the wavelength range from 800 nm to 3 µm, by at least 1%, advantageously by at least 2%, more advantageously by at least 3%.

The inventors have found that the reference reflectance in the infrared wavelength range, in particular between 800nm and 3 µm, may be reduced to a minimum at a certain wavelength *λ* ₘᵢₙ, by using ions implanted with an acceleration voltage that depends on the standard atomic weight of the implanted ions. The standard atomic weight is the relative atomic mass as defined by the international union of pure and applied chemistry IUPAC. When a mixture of ions is implanted, be it a mixture of different isotopes or a mixture of ions from different chemical elements, the average standard atomic weight Zₐᵥᵣ is the average of the relative atomic masses of the ions used.

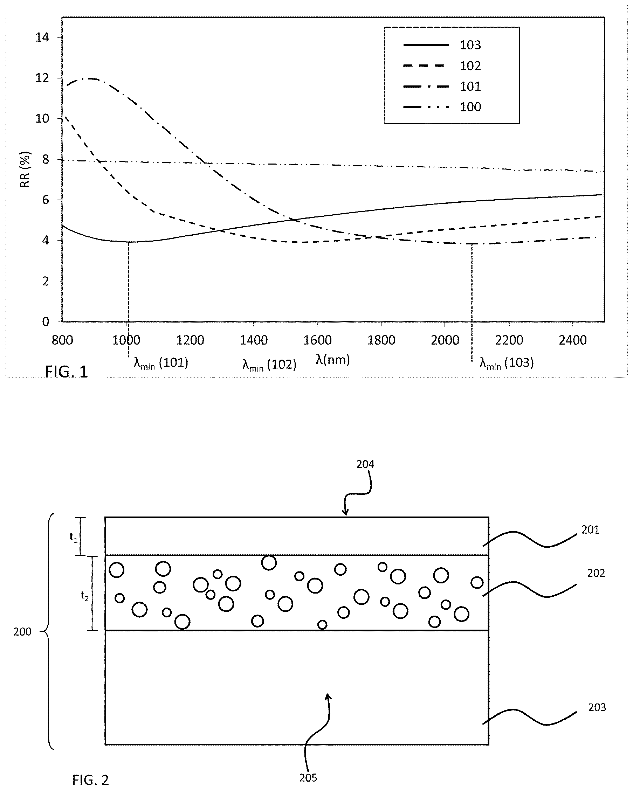

Figure 1 shows the reference reflectance (RR) curves in a wavelength ( *λ* ) range from 800 nm to 2500 nm for three different substrates (101, 102, 103) for transmitting IR light according to certain embodiments of the present invention, compared to an non-treated substrate (100). Each of the three reference reflectance curves (101, 102, 103) shows a minimum reference reflectance at a certain wavelength *λ* ₘᵢₙ (101), *λ* ₘᵢₙ (102), and *λ* ₘᵢₙ (103).

According to an embodiment of the present invention, the reference reflectance is reduced in the infrared wavelength range from 800 nm to 3 µm, with a minimum at the wavelength *λ* ₘᵢₙ when the ions are implanted with an acceleration voltage AV such that ratio of the acceleration voltage AV to the average standard atomic weight Zₐᵥᵣ of the implanted ions is comprised in the range from 0.0029 × *λ* ₘᵢₙ × kV/nm - 1.25 kV to 0.0026 × *λ* ₘᵢₙ × kV/nm + 0.68 kV, with *λ* ₘᵢₙ being wavelength of the minimum of the reference reflectance in the infrared wavelength range from 800 nm to 3 µm.

The present invention, in certain embodiments, also concerns the use of a bi-layer within a substrate, to reduce the reference reflectance of the substrate in the wavelength range from 800 nm to 3 µm.

The bi-layer comprises, starting from the substrate surface and going towards the core of the substrate, a first layer having almost the same refractive index as the bulk substrate, and a porous second layer, having a refractive index lower than the bulk substrate. The first layer has a refractive index n₁ where 0.95 × n_{b} ≤ n₁ ≤ 1.05 × n_{b}, n_{b} being the refractive index of the bulk substrate, and the second layer has a refractive index n2, wherein n₂ < n_{b}, the refractive index being the average refractive index in the wavelength range from 800 nm to 3 µm. Preferably the solid phase of first and second layers, that is the part of the first and second layers that is not a pore, consists essentially of the same material as the bulk material of the substrate. Essentially the same material in the present case means that the material is the same except for components, such as alkali-ions, that may be present in the substrate and that are susceptible to migrate towards the core of the substrate upon ion implantation.

Figure 2 shows an exemplary embodiment (not to scale) of a substrate for transmitting infrared light (200), having, starting from the substrate surface (204) and going towards the core of the substrate (205), a first layer (201) having the same refractive index as the bulk substrate, and a porous second layer (202), having a refractive index lower than the bulk substrate. The first layer has a thickness t₁ and the porous second layer has a thickness t₂.

The first layer has no detectable porosity. The lower size limit of detectability of pores is about 3 nm in diameter. The pores of the porous second layer are filled with the gas formed by recombination of the implanted ions. Implanted ions formed from the same gas are to be found throughout the solid material of the first layer at a concentration of less than 10 atom %.

For the purpose of the present invention the refractive index is the average refractive index in the wavelength range from 800 nm to 3 µm.

In an embodiment of the present invention, the first layer may have a thickness t₁ in the range from 10 nm to 120 nm, the porous second layer having a thickness t₂ in the range from 110 nm to 400 nm and the ratio t₂/t₁ being in the range from 3 to 11. All thicknesses herein are geometrical, or physical thicknesses unless otherwise noted.

In particular the porous second layer may have a pore density in the range from 15 to 80%, advantageously in the range from 25 to 70 %, more preferably in the range from 25 to 65%. The pore density is determined on a TEM image of a cross section of the porous layer as explained below. Higher pore density is beneficial for low reference reflectance, but tends to reduce the mechanical durability of the treated substrate. A good compromise between reference reflectance reduction and mechanical durability is obtained with the pore density in the range from 30 to 60%, in particular when combined with the layer thicknesses hereinabove.

According to another embodiment of the present invention, the reference reflectance is reduced in the infrared wavelength range from 800 nm to 3 µm, with a minimum at the wavelength *λ* ₘᵢₙ when the first layer has a thickness in the range from 0.04 × *λ* ₘᵢₙ - 21 nm to 0.04 × *λ* ₘᵢₙ - 15 and the porous second layer has a thickness in the range from 0.11 × *λ* ₘᵢₙ + 24 nm to 0.11 × *λ* ₘᵢₙ + 88 nm, with *λ* ₘᵢₙ being wavelength of the minimum of the reference reflectance in the infrared wavelength range from 800 nm to 3000 nm.

According to certain embodiments of the invention hereinabove the average reference reflectance of the substrate in the IR wavelength range from 800 nm to 3 µm, in particular from 800 nm to 2.5 µm, is reduced by 1%, in particular by 2%, and even by 3% of the total incoming light.

According to an embodiment of the present invention the reference reflectance of the substrate at a selected wavelength *λ* ₘᵢₙ in the IR wavelength range from 800 m to 3 µm, in particular from 800 nm to 2.5 µm, is reduced by 1.5%, in particular by 2.5%, and even by 3.5% of the total incoming light.

According to an embodiment of the present invention the average reference reflectance in the wavelength range from 800 nm and 1600 nm is reduced by 1%, in particular by 2%, and even by 3% of the total incoming light.

According to certain embodiments of the invention *λ* ₘᵢₙ is in the wavelength range from 800 nm to 1200 nm, in particular from 900 to 1100 nm. It was found that the treated substrate of the present invention then has a neutral or green-blue color in reflection. In particular the CIELAB color coordinates of the reflected light on the ion implanted side of the substrate, expressed by the color coordinates of a*_{Rc} and b* _{Rc} in reflection, is neutral or blue-green, that is -10 ≤ a* _{Rc} ≤ 1 and -20 ≤ b* _{Rc} ≤ 1, or is closer to neutral or has a less intense blue-green tint, that is -5 ≤ a* _{Rc} ≤ 0.5 and -15 ≤ b* _{Rc} ≤ 0.5, or even is very neutral or has a slight blue-green tint, that is -4 ≤ a* _{Rc} ≤ 0 and -10 ≤ b* _{Rc} ≤ 0.

According to the present invention the substrate is chosen among soda-lime-silica glass, alumino-silicate glass and boro-silicate glass.

According to the present invention the substrate may be a plano-optic substrate, for example a window, mirror, polarizer, beamsplitter, or prism, a spherical lens, for example a plano-concave/convex, doubleconcave/convex, or meniscus lens, an aspheric lens, for example a parabolic, hyperbolic, or hybrid lens, or an achromatic lens. According to the present invention the substrate may be part of an optical assembly, for example an imaging lens, a beam expander, an eyepiece, an objectives, or glasses. The substrate of the present invention may in particular be a window or a lens for transmitting infrared light from an infrared lamp or an infrared laser, for example a laser emitting infrared light in the wavelength range from 800 nm to 1.6 µm. In particular the substrate may be a substrate to transmit of an infrared laser of a wavelength *λ* _{L} , preferably the substrate has a minimum of reflectance at a wavelength *λ* ₘᵢₙ, where 0.95 *λ* _{L} ≤ *λ* ₘᵢₙ ≤ 1.05 *λ* _{L}.

According to advantageous embodiments of the present invention the temperature of the substrate is kept during implantation below the glass-transition temperature of the substrate. Preferably the temperature is kept below 600° C, more preferably below 500° C, most preferably below 400° C.

In particular, the glass composition of the substrate of the present invention comprises, expressed on oxide basis as percentages by weight total glass:

| | |
|---|---|
| SiO₂ | 55-85%, |
| Al₂O₃ | 0-30%, |
| B₂O₃ | 0-20%, |
| Na₂O | 0-25%, |
| CaO | 0-20%, |
| MgO | 0-15%, |
| K₂O | 0-20%, |
| BaO | 0-20%. |

In another particular embodiment, the glass composition of the optical element of the present invention comprises, expressed on oxide basis as percentages by weight total glass:

| | |
|---|---|
| SiO₂ | 55-78%, |
| Al₂O₃ | 0-18%, |
| B₂O₃ | 0-18%, |
| Na₂O | 0-20%, |
| CaO | 0-15%, |
| MgO | 0 - 10%, |
| K₂O | 0 - 10%, |
| BaO | 0-5%. |

In particular, the borosilicate glass composition of the optical element of the present invention comprises, expressed on oxide basis as percentages by weight total glass:

| | |
|---|---|
| SiO₂ | 60-70 %, |
| B₂O₃ | 10-20 %, |
| K₂O | 5-15 %, |
| Na₂O | 1-15 %, |
| BaO | 1-10 %, |
| Sb₂O₃ | <1 %, |
| CaO | <1 %, |
| TiO₂ | <1 %, |
| ZnO | <1 %. |

Optionally this borosilicate glass composition further comprises 1 to 5% by weight of CeO₂, for increased resistance to radiation, in particular ionizing radiation.

In an advantageous embodiment, the glass of the optical element of the present invention comprises, for reasons of lower production costs, is soda-lime glass. Advantageously, according to this embodiment, the glass composition of the optical element of the present invention comprises, expressed on oxide basis as percentages by weight total glass:

| | |
|---|---|
| SiO₂ | 60-75%, |
| Al₂O₃ | 0-6%, |
| B₂O₃ | 0-4%, |
| Na₂O | 5-20%, |
| CaO | 0-15%, |
| MgO | 0-10%, |
| K₂O | 0-10%, |
| BaO | 0-5%. |

In addition to its any of its compositions hereinabove, the glass may comprise other components, nature and amount of which may vary depending on the desired effect.

Optionally, to further increase transmittance of IR light, the glass composition of the optical element of the present invention further comprises chromium, in a range of specific contents.

Thus, according to an optional embodiment of the present invention, the glass composition of the optical element of the present invention further comprises, expressed on oxide basis as percentages by weight total glass:

| | |
|---|---|
| Total iron (expressed as Fe₂O₃) | 0.002 to 0.06%, |
| Cr₂O₃ | 0.0001 to 0.06%. |

Such glass compositions combining low levels of iron and chromium show particularly good performance in terms of infrared transmittance as well as transmittance in the visible range and neutral colors in transmittance. Exemplary glass compositions thereof are described in international applications: WO2014128016A1, WO2014180679A1, WO2015011040A1, WO2015011041A1, WO2015011042A1, WO2015011043A1, and WO2015011044A1. In particular these glass compositions advantageously comprise chromium (expressed as Cr₂O₃) ranging from 0.002 to 0.06% by weight relative to the total weight of the glass. Such chromium contents can further improve the infrared transmittance.

Thus, according to another optional embodiment of the present invention, the glass composition of the optical element of the present invention further comprises, expressed on oxide basis as percentages by weight total glass:

| | |
|---|---|
| Total iron (expressed as Fe₂O₃) | 0.002 to 0.06%, |
| Cr₂O₃ | 0.0015 to 1%, |
| Co | 0.0001 to 1%. |

Such chromium and cobalt-based glass compositions show particularly good performance in terms of infrared transmittance, while offering interesting possibilities in terms of aesthetics or color (from blue to neutral intense staining or until 'opacity). Exemplary compositions hereof are disclosed in Patent Application WO2015091106 A1.

According to another optional embodiment of the present invention, the glass composition of the optical element of the present invention further comprises, expressed on oxide basis as percentages by weight total glass:

| | |
|---|---|
| Total iron (expressed as Fe₂O₃) | 0.002 to 1%, |
| Cr₂O₃ | 0.002 to 0.5%, |
| Co | 0.0001 to 0.5% |

Advantageously, according to this embodiment, the composition comprises: 0.06% < Total iron ≤ 1%.

Such compositions based on chromium and cobalt may be used to obtain colored glass sheets in the blue-green range, comparable in terms of color and light transmission with traditional soda-lime based blue and green glasses, but with particularly high infrared transmittance. Exemplary compositions hereof disclosed in Patent Application WO2016202606 A1.

According to another optional embodiment of the present invention, the glass composition of the optical element of the present invention further comprises, expressed on oxide basis as percentages by weight total glass:

| | |
|---|---|
| Total iron (expressed as Fe₂O₃) | 0.002 to 1%, |
| Cr₂O₃ | 0.002 to 0.5%, |
| Co | 0.0001 to 0.5%, |
| Se | 0.0003 to 0.5%. |

Such glass compositions based on chromium, cobalt and selenium have shown particularly good performance in terms of infrared transmittance, while offering interesting possibilities in terms of aesthetics / color (gray neutral to slight staining intense in the graybronze range). Such compositions are disclosed in Patent Application WO2016202689 A1.

Optionally, as an alternative to chromium, the glass composition of the optical element of the present invention further comprises other components in specific concentrations to further increase transmittance of IR light.

According to an alternate optional embodiment of the present invention, the glass composition of the optical element of the present invention further comprises, expressed on oxide basis as percentages by weight total glass:

| | |
|---|---|
| Total iron (expressed as Fe₂O₃) | 0.002 to 0.6%, |
| CeO₂ | 0.001 to 1%. |

Such compositions are disclosed in Patent Application WO2015071456 A1.

According to another alternate optional embodiment of the present invention, the glass composition of the optical element of the present invention further comprises, expressed on oxide basis as percentages by weight total glass:

| | |
|---|---|
| Total iron (expressed as Fe₂O₃) | 0.002 to 0.06%, |

and one of the following components:
manganese (expressed as MnO) in an amount ranging from 0.01 to 1% by weight;
antimony (expressed as Sb₂O₃), in an amount ranging from 0.01 to 1% by weight;
arsenic (expressed as As₂O₃), in an amount ranging from 0.01 to 1% by weight, or
copper (expressed as CuO), in an amount ranging from 0.0002 to 0.1% by weight.

Such compositions are disclosed in Patent Application WO2015172983 A1.

According to another alternate optional embodiment of the present invention, the glass composition of the optical element of the present invention further comprises, expressed on oxide basis as percentages by weight total glass:

| | |
|---|---|
| Total iron (expressed as Fe₂O₃) | 0.002 to 0.04%, |

and one of the and at least two components among chromium, selenium, copper, cerium, manganese and antimony; with chromium (expressed as Cr₂O₃) being a maximum content of 0.02% by weight; selenium (expressed as Se) being a maximum content of 0.08% by weight; copper (expressed as CuO) being a maximum content of 0.04% by weight; cerium (calculated as CeO₂) being a maximum content of 0.8% by weight; manganese (calculated as MnO) being a maximum content of 1.6% by weight; antimony (expressed as Sb₂O₃) being a maximum content of 0.8% by weight; said composition having the formula:
A ≤ [10.02 * (Cr₂O₃ / Fe₂O₃) + 4 * (Se / Fe₂O₃) + 2.73 * (CuO / Fe₂O₃) + 0.7 * (CeO₂ / Fe₂O₃) + 0.23 * (MnO / Fe₂O₃) + 0.11 * (Sb₂O₃ / Fe₂O₃)]; A being equal to 0.30.

Such compositions are disclosed in European Patent Application No. WO2016008906 A1.

According to an advantageous embodiment of the invention, the composition of the glass sheet has a redox of less than 15%. Preferably, the redox is lower than 10%, or less than 5% or even less than 3%. The degree of oxidation of a glass is given by the redox, defined as the ratio of atom weight of Fe²⁺ based on the total weight of iron atoms Feₜₒₜ present in the glass, Fe²⁺ / Feₜₒₜ.

The inventors surprisingly found that the ion implantation of a mixture of single charge and multicharge ions led to a reflectance curve that was very flat around *λ* ₘᵢₙ. In particular the ion implantation of the present invention may lead to a less steep increase of reference reflectance towards wavelengths < *λ* ₘᵢₙ, in particular when compared to the ion implantation of single charge ions only. In particular the ion implantation of the present invention may lead to a less high increase of reference reflectance towards wavelengths < *λ* ₘᵢₙ, in particular when compared to the ion implantation of single charge ions only.

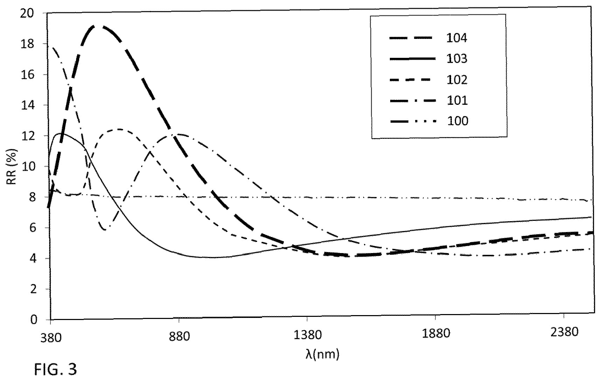

Figure 3 shows the reference reflectance (RR) curves in a wavelength (*λ*) range from 380 nm to 2500 nm for three different substrates (101, 102, 103) for transmitting IR light according to certain embodiments of the present invention, of a non-treated substrate (100) and of a treated substrate (104), not according to the present invention, implanted with Kr⁺ single charge ions at an energy of 200keV and a dosage of 2.5 x 10¹⁶ ions/cm². The reference reflectance curves of substrates treated according to the present invention show, in particular in comparison with substrate (104), a flat reflectance curve, a limited increase of reflectance in the visible wavelength range, and a less steep increase of reflectance towards wavelengths that are smaller than the wavelength of minimum reference reflectance. The RR curve of substrate (104) is extrapolated from reflectance data reported in POLATO Pietro. et al., Characterization by Nuclear and Spectrophotometric Analysis of Near - Surface Modifications of Glass Implanted with Heavy Ions, Journal of the American Chemical Society, vol. 70, no.10, pages 775-779.

In certain embodiments of the present invention, the ion implantation leads to a limited increase of reference reflectance in the visible light range.

In an embodiment of the present invention, the reference reflectance of a treated substrate at a wavelength *λ* ₋₅₀₀, wherein *λ* ₋₅₀₀= *λ* ₘᵢₙ- 500nm, does not rise above 13%.

In an embodiment of the present invention, the reference reflectance of a treated substrate does not rise above 13% in the visible light range of wavelengths between 380nm and 780nm.

In an embodiment of the invention the ion implantation furthermore results in a reduction of the visible light reference reflectance, in particular for *λ* min ≤1100nm, more particularly for *λ* min ≤1000nm.

According to certain embodiments, the reference reflectance in the visible range of a treated substrate is at most 7%, in particular for *λ* min ≤1100nm, more particularly for *λ* min ≤1000nm..

In a preferred embodiment of the present invention the bulk temperature of the area of the glass substrate being treated, situated under the area being treated is less than or equal to the glass transition temperature of the glass substrate. This temperature is for example influenced by the ion current of the beam, by the residence time of the treated area in the beam and by any cooling means of the substrate.

The implantation of ions according to the present invention is preferably performed in a vacuum chamber at a pressure comprised between 10⁻⁷ mbar and 10⁻² mbar, more preferably at a pressure comprised between 5 × 10⁻⁵ mbar and 2 × 10⁻⁶ mbar.

The pores of the porous second layer are filled with a gas. Ions formed of the same gas are to be found throughout the solid material both the first and the porous second layers.

An example ion source for carrying out the method of the present invention is the Hardion+ ECR ion source from Ionics SA.

The present invention also concerns the use of a mixture of single charge and multicharge ions of N, H, O, He, Ne, Ar, or Kr to decrease the reference reflectance of an etched glass substrate, the mixture of single charge and multicharge ions being implanted in the glass substrate with an ion dosage and acceleration voltage effective to reduce the reference reflectance of the glass substrate.

Advantageously the implantation depth of the ions may be comprised between 0.11 µm and 1 µm, preferably between 0.15 µm and 0.5 µm. The implanted ions are spread between the substrate surface and the implantation depth. The implantation depth may be adapted by the choice of implanted ion, by the acceleration energy and varies to a certain degree depending on the substrate.

According to the present invention, the mixture of single charge and multicharge ions of O or N preferably comprises, O⁺ and O²⁺ or N⁺, N²⁺ and N³⁺ respectively.

According to a preferred embodiment of the present invention, mixture of single charge and multicharge ions of O comprises a lesser amount of O²⁺ than of O⁺. In a more preferred embodiment of the present invention the mixture of single charge and multicharge ions of O comprises 55-98% of O⁺ and, 2-45% of O²⁺.

According to another preferred embodiment of the present invention, mixture of single charge and multicharge ions of N comprises a lesser amount of N³⁺ than of N⁺ and of N²⁺each. In a more preferred embodiment of the present invention the mixture of single charge and multicharge ions of N comprises 40-70% of N⁺, 20-40% of N²⁺, and 2-20% of N³⁺.

According to another preferred embodiment, the glass sheet of the invention is a glass sheet formed by a slot draw process or by a fusion process, in particular the overflow downdraw fusion process. These processes, in particular the fusion process produces glass sheets whose surfaces may reach superior flatness and smoothness necessary in some applications, but they are also more expensive than the float process for large scale glass production.

The substrate according to the invention may have a thickness of from 0.1 to 25 mm. Advantageously, in the case of display applications, the glass sheet according to the invention has preferably a thickness of from 0.1 to 6 mm. More preferably, in the case of display applications and for reasons of weight, the thickness of the glass sheet according to the invention is of from 0.1 to 2.2 mm.

In certain applications the substrate according to the invention may have a thickness of from 10µm to 100 µm, advantageously from 50 µm to 100 µm.

Another additional objective of the invention is to provide an optical assembly for emitting, detecting or measuring infrared light at a wavelength *λ* _{L} in the range between 800 nm and 3 µm comprising
a. a substrate for transmitting infrared light according to any embodiment of the invention hereinabove, thus having low reference reflectance in the infrared light range between 800 nm and 3 µm and
b. an infrared sensitive optical component and/or an infrared light source.

Infrared sensitive optical components, or infrared sensors, may comprise an IR detector, such as a motion sensor or a pyrometer for example, an imaging sensor, such as a charge coupled device or a microbolometer array,

Infrared light sources may be infrared lasers or lamps for example. It may also be a hot object, emitting thermal radiation in the infrared range.

The optical assembly may comprise both an infrared light source and an infrared sensitive optical component, such as in a light detection and ranging (LIDAR) device.

The optical assembly of the present invention may also comprise additional optical elements, such as for example lenses, prisms, or covers. These may be substrates according to the present invention or not.

Embodiments of the invention will now be further described, by way of examples only, together with some comparative examples, not in accordance with the invention. The following examples are provided for illustrative purposes, and are not intended to limit the scope of this invention.

### Examples

The microstructure of the treated substrates, the layer thicknesses and in particular pore density were investigated by Transmission Electron Microscope (TEM). Cross-sectional specimens were prepared using Focused In Beam (FIB) procedure. During the preparation process carbon and platinum protective layers were deposited on top of the film. For the purpose of the present invention the pore densities as determined by the present method on a two-dimensional image are considered to be representative of the three-dimensional size and densities of the pores.

The images from the TEM were processed with image analysis software ImageJ (developed by the National Institutes of Health, USA) to identify the pores as well-defined bright areas. The cross-sectional equivalent circular diameter of a pore, usually having an irregular shape, is the diameter of a two-dimensional disk having an equivalent area to the cross-section of the pore as determined by this image analysis method. The pore density was evaluated as the percentage of the cross-section area of the porous second layer occupied by pores.

The layer thicknesses were also evaluated on the TEM micrographs.

The ion implantation examples were prepared according to the various parameters detailed in the tables below using an ECR ion source for generating a beam of a mixture of single charge and multicharge ions. The ion source used was a Hardion+ ECR ion source from Ionics S.A.

All samples had a size of about 100 cm² and were treated on the entire surface by displacing the substrate through the ion beam at a speed selected between 10 and 100 mm/s.

The temperature of the area of the substrate being treated was kept at a temperature less than or equal to the melting temperature of the substrate.

For all examples the implantation was performed in a vacuum chamber at a pressure of 10⁻⁶ mbar.

Using the ECR ion source, and a N₂ source gas, ions of N were implanted in 1.6 mm thick substrates of normal clear soda lime glass. Before being implanted with the ion implantation method of the present invention the average reference reflectance (avg RR) of the glass substrates in the wavelength range from 800 nm to 2.5 µm was 7.7%. The key implantation parameters can be found in table 1 below. Table 1 also shows for each sample the average reference reflectance (avg RR), the wavelength of minimum reference reflectance *λ* ₘᵢₙ, and the reference reflectance (RR) at *λ* ₘᵢₙ.

**Table 1**

| | ion implantation treatment | | | (avg RR) 800 nm to 2.5µm | *λ* ₘᵢₙ | RR at *λ* ₘᵢₙ |
|---|---|---|---|---|---|---|
| sample numbe r | source gas | acceleratio n voltage | dosage | | | |
| | | [kV] | [ions/cm²] | [%] | [nm] | [%] |
| E1 | N₂ | 20 | 8 × 10¹⁶ | 7.0 | 870 | 6.0 |
| E2 | N₂ | 25 | 8 × 10¹⁶ | 7.0 | 805 | 6.2 |
| E3 | N₂ | 25 | 9 × 10¹⁶ | 6.7 | 860 | 4.4 |
| E4 | N₂ | 30 | 8 × 10¹⁶ | 6.7 | 860 | 5.7 |
| E5 | N₂ | 30 | 9 × 10¹⁶ | 6.6 | 880 | 5.4 |
| E6 | N₂ | 35 | 8 × 10¹⁶ | 6.3 | 880 | 4.7 |
| E7 | N₂ | 35 | 9 × 10¹⁶ | 6.4 | 880 | 4.6 |
| REF | | | | 7.7 | | |

The inventors found that similar results as with the implantation of N from N₂ source gas were found with the implantation of ions of O, He, Ne, Ar, and Kr, when the acceleration voltage was adapted relative to the average atomic mass of the implanted ions.

Analysis of substrates of the present invention obtained by the implantation of ions of nitrogen showed no significant formation of silicon nitride Si₃N₄.

Table 2 shows acceleration voltages leading each to comparable results for implanted ions N, He, or Kr.

**Table 2**

| Source gas | Acceleration voltage | *λ* ₘᵢₙ | RR at *λ* ₘᵢₙ | t1 | t2 | Pore density |
|---|---|---|---|---|---|---|
| | [kV] | [nm] | [%] | [nm] | [nm] | [%] |
| N₂ | 35 | 1000 | 3.9 | 25 | 145 | 60 |
| He | 10 | | | | | |
| Kr | 170 | | | | | |
| N₂ | 55 | 1500 | 3.9 | 40 | 210 | 60 |
| He | 14 | | | | | |
| Kr | 250 | | | | | |
| N₂ | 70 | 2000 | 3.9 | 52.5 | 287.5 | 60 |
| He | 20 | | | | | |
| Kr | 350 | | | | | |
| N₂ | 90 | 2500 | 3.8 | 87.5 | 387.5 | 60 |
| He | 25 | | | | | |
| Kr | 400 | | | | | |

As can be seen from table 2 above, by adapting the acceleration voltage, comparable reflectance results can be achieved for a wide range of implanted ions.

Table 3 shows for each sample the reference reflectance at *λ* ₋₅₀₀, wherein *λ* ₋₅₀₀ = *λ* ₘᵢₙ - 500nm, and the maximum reflectance in the wavelength range 380nm to 780nm.

**Table 3**

| sample numbe r | RR at *λ* ₋₅₀₀ | *λ* ₋₅₀₀ | Max. RR from 380nm to 780nm |
|---|---|---|---|
| | [%] | [nm] | [%] |
| E1 | 7.1 | 370 | 6.7 |
| E2 | 8.1 | 305 | 7.6 |
| E3 | 9.9 | 360 | 8.8 |
| E4 | 10.7 | 360 | 9.6 |
| E5 | 9.5 | 380 | 9.5 |
| E6 | 13.0 | 380 | 13.0 |
| E7 | 11.7 | 380 | 11.7 |

## Claims

1. Use of implanted ions to decrease the infrared reflectance in the wavelength range between 800 nm and 3 µm of a substrate for transmitting infrared light, wherein
a. the ions are selected from a mixture of single charge and multicharge ions of the ions of N, O, He, Ne, Ar, or Kr; and
b. are implanted in the substrate with a dosage comprised between 10¹⁶ ions/cm² and 2 × 10¹⁷ ions/cm², and an acceleration voltage AV comprised between 5.5 kV and 450 kV, and
wherein the substrate is chosen among the substrates of soda-lime-silica glass, alumino-silicate glass and boro-silicate glass.

2. Use of implanted ions to decrease the infrared reflectance of a substrate for transmitting infrared light according to claim 1, wherein the ions are implanted in the substrate with a dosage comprised between 10¹⁶ ions/cm² and 1.5 × 10¹⁷ ions/cm², preferably between 10¹⁶ ions/cm² and 9.5 × 10¹⁶ ions/cm².

3. Use of implanted ions to decrease the infrared reflectance of a substrate for transmitting infrared light according to claim 1, wherein the substrate is a soda-lime glass substrate comprising a content, expressed as the total weight of glass percentages:
a. total iron (expressed as Fe₂O₃) 0.002 to 0.06%, and
b. Cr₂O₃ 0.0001 to 0.06%.

4. Use of implanted ions to decrease the infrared reflectance of a substrate for transmitting infrared light according to any one preceding claim, wherein the substrate is a plano-optic substrate or a lens.

5. Use of implanted ions to decrease the infrared reflectance of a substrate for transmitting infrared light according to any one preceding claim, wherein the average reference reflectance of the substrate in the wavelength range between 800nm and 3µm is reduced by at least 1%, preferably by at least 2%, more preferably by at least 3%.

6. Use of implanted ions to decrease the infrared reflectance of a substrate for transmitting infrared light, according to any one preceding claim, wherein the reference reflectance of the substrate presents a minimum, at a wavelength *λ* ₘᵢₙ, with 800 nm ≤ *λ* ₘᵢₙ ≤ 3 µm.

7. Use of implanted ions to decrease the infrared reflectance of a substrate for transmitting infrared light, according to any one preceding claim wherein the reference reflectance of the substrate at a wavelength *λ* ₋₅₀₀ is at most 13%, with *λ* ₋₅₀₀ = *λ* ₘᵢₙ - 500nm.

8. Use of implanted ions to decrease the infrared reflectance of a substrate for transmitting infrared light, according to any one preceding claim wherein the reference reflectance of the substrate in the visible light wavelength range is at most 13%.

9. Use according to any one preceding claim wherein
a. the ratio AV/Zₐᵥᵣ of the acceleration voltage AV to the average standard atomic weight Zₐᵥᵣ of the ions is comprised in the range from 0.0029 × *λ* ₘᵢₙ × kV/nm-1.25 kV to 0.0026 × *λ* ₘᵢₙ × kV/nm + 0.68 kV, with *λ* ₘᵢₙ being wavelength of the minimum of the reference reflectance in the infrared wavelength range from 800 nm to 3 µm.

10. Use of a bi-layer within a substrate to decrease the infrared reference reflectance of the substrate, wherein
a. the bi-layer comprises, starting from the substrate surface and going towards the core of the substrate,
i. a first layer having a refractive index n₁ where 0.95 × n_{b} ≤ n₁ ≤ 1.05 × n_{b}, n_{b} being the refractive index of the bulk substrate, and
ii. a second layer, which is a porous layer, having a refractive index n₂, wherein n₂ < n_{b} ,
the respective refractive indexes being the average refractive indexes in the wavelength range from 800 nm to 3 µm, and wherein preferably the solid phase of first and second layers consists essentially of the same material as the bulk material of the substrate, and wherein the substrate is chosen among the substrates of soda-lime-silica glass, alumino-silicate glass and borosilicate glass.

11. Use of a bi-layer within a substrate to decrease the infrared reference reflectance of the substrate according to claim 10, wherein
a. the first layer has a thickness in the range from 10 to 120 nm,
b. the porous second layer has thickness in the range from 110 to 400 nm and a pore density in the range from 40% to 80%.

12. Optical assembly for controlling infrared light in the range between 800 nm and 3 µm comprising an ion implanted substrate for transmitting infrared light in the infrared light range between 800 nm and 3 µm and an infrared sensitive optical component and/or an infrared light source, wherein
a. the implanted ions are a mixture of single charge and multicharge ions, selected from one or more of the ions of N, H, O, He, Ne, Ar, and Kr and
b. are implanted in the substrate with a dosage comprised between 10¹⁶ ions/cm² and 2 × 10¹⁷ ions/cm², and an acceleration voltage AV comprised between 5.5 kV and 450 kV.
and wherein the substrate is chosen among the substrates of soda-lime-silica glass, alumino-silicate glass and boro-silicate glass.

13. Optical assembly for controlling infrared light in the range between 800 nm and 3 µm comprising a substrate for transmitting infrared light in the infrared light range between 800 nm and 3 µm and an infrared sensitive optical component and/or an infrared light source, wherein the substrate for transmitting infrared light comprises a bi-layer, the bi-layer comprising, starting from the substrate surface and going towards the core of the substrate, a first layer having a refractive index n₁ where 0.95 × n_{b} ≤ n₁ ≤ 1.05 × n_{b}, n_{b} being the refractive index of the bulk substrate, and a second layer, which is a porous layer, having a refractive index n₂, wherein n₂ < n_{b}, the respective refractive indexes being the average refractive indexes in the wavelength range from 800 nm to 3 µm, and wherein the reference reflectance of the substrate presents a minimum, at a wavelength *λ* ₘᵢₙ, with 800nm ≤ *λ* min ≤ 3µm and wherein the reference reflectance of the substrate at a wavelength *λ* ₋₅₀₀ is at most 13%, with *λ* ₋₅₀₀ = *λ* ₘᵢₙ - 500nm, and wherein the substrate is chosen among the substrates of soda-lime-silica glass, alumino-silicate glass and boro-silicate glass.

14. Optical assembly according to claim 13 wherein the first layer has a thickness in the range from 10 to 120 nm, and the porous second layer has thickness in the range from 110 to 400 nm and a pore density in the range from 40% to 80%.

15. Optical assembly according to any one of claims 12 to 14 comprising an infrared light source, wherein the infrared light source is an infrared laser emitting at a wavelength *λ* _{L} and wherein the reference reflectance of the substrate presents a minimum, at a wavelength *λ* ₘᵢₙ, with 0.95 *λ* _{L} ≤ *λ* ₘᵢₙ ≤ 1.05 *λ* _{L}.

## Patentansprüche

1. Verwendung von implantierten Ionen zur Verminderung des Infrarotreflexionsvermögens im Wellenlängenbereich zwischen 800 nm und 3 µm eines Substrats zum Übertragen von Infrarotlicht, wobei
a. die Ionen ausgewählt sind aus einer Mischung aus einfach geladenen und mehrfach geladenen Ionen aus den Ionen von N, O, He, Ne, Ar oder Kr; und
b. in dem Substrat mit einer Dosis zwischen 10¹⁶ Ionen/cm² und 2 × 10¹⁷ Ionen/cm² und einer Beschleunigungsspannung AV zwischen 5,5 kV und 450 kV implantiert werden,
wobei das Substrat ausgewählt ist aus den Substraten von Natriumkalkquarzglas, Aluminosilikatglas und Borsilikatglas.

2. Verwendung von implantierten Ionen zur Verminderung des Infrarotreflexionsvermögens eines Substrats zum Übertragen von Infrarotlicht nach Anspruch 1, wobei die Ionen in dem Substrat mit einer Dosierung zwischen 10¹⁶ Ionen/cm² und 1,5 × 10¹⁷ Ionen/cm², vorzugsweise zwischen 10¹⁶ Ionen/cm² und 9,5 × 10¹⁶ Ionen/cm² implantiert sind.

3. Verwendung von implantierten Ionen zur Verminderung des Infrarotreflexionsvermögens eines Substrats zum Übertragen von Infrarotlicht nach Anspruch 1, wobei das Substrat ein Natriumkalkglassubstrat ist, das einen Gehalt an folgendem umfasst, angegeben in Prozent, bezogen auf das Gesamtgewicht des Glases:
a. Gesamteisen (angegeben als Fe₂O₃) 0,002 bis 0,06 % und
b. Cr₂O₃ 0, 0001 bis 0, 06 %.

4. Verwendung von implantierten Ionen zur Verminderung des Infrarotreflexionsvermögens eines Substrats zum Übertragen von Infrarotlicht nach einem der vorhergehenden Ansprüche, wobei das Substrat ein Planoptiksubstrat oder eine Linse ist.

5. Verwendung von implantierten Ionen zur Verminderung des Infrarotreflexionsvermögens eines Substrats zum Übertragen von Infrarotlicht nach einem der vorhergehenden Ansprüche, wobei das durchschnittliche Referenzreflexionsvermögen des Substrats im Wellenlängenbereich zwischen 800 nm und 3 µm um mindestens 1 %, vorzugsweise mindestens 2 %, bevorzugter mindestens 3 % reduziert wird.

6. Verwendung von implantierten Ionen zur Verminderung des Infrarotreflexionsvermögens eines Substrats zum Übertragen von Infrarotlicht nach einem der vorhergehenden Ansprüche, wobei das Referenzreflexionsvermögen des Substrats bei einer Wellenlänge λₘᵢₙ, wobei 800 nm ≤ λₘᵢₙ ≤ 3 µm, ein Minimum aufweist.

7. Verwendung von implantierten Ionen zur Verminderung des Infrarotreflexionsvermögens eines Substrats zum Übertragen von Infrarotlicht nach einem der vorhergehenden Ansprüche, wobei das Referenzreflexionsvermögen des Substrats bei einer Wellenlänge λ-₅₀₀ höchstens 13 % beträgt, wobei λ-₅₀₀ = λₘᵢₙ - 500 nm

8. Verwendung von implantierten Ionen zur Verminderung des Infrarotreflexionsvermögens eines Substrats zum Übertragen von Infrarotlicht nach einem der vorhergehenden Ansprüche, wobei das Referenzreflexionsvermögen des Substrats im Wellenlängenbereich des sichtbaren Lichts höchstens 13 % beträgt.

9. Verwendung nach einem der vorhergehenden Ansprüche, wobei:
a. das Verhältnis AV/Zₐᵥᵣ der Beschleunigungsspannung AV zu dem durchschnittlichen Standardatomgewicht Zₐᵥᵣ der Ionen im Bereich von 0,0029 × λₘᵢₙ × kV/nm - 1,25 kV bis 0,0026 × λₘᵢₙ × kV/nm + 0,68 kV liegt, wobei λₘᵢₙ die Wellenlänge des Minimums des Referenzreflexionsvermögens im Infrarotwellenlängenbereich von 800 nm bis 3 µm ist.

10. Verwendung einer Doppelschicht innerhalb eines Substrats zur Verminderung des Infrarotreferenzreflexionsvermögens des Substrats, wobei
a. die Doppelschicht, ausgehend von der Substratoberfläche und in Richtung des Kerns des Substrats gehend, folgendes umfasst:
i. eine erste Schicht mit einem Brechungsindex n₁, wobei
0,95 × n_{b} ≤ n₁ ≤ 1,05 × n_{b}, wobei n_{b} der Brechungsindex des Massensubstrats ist, und
ii. eine zweite Schicht, die eine poröse Schicht ist, mit einem Brechungsindex n₂, wobei n₂ ≤ n_{b},
wobei die jeweiligen Brechungsindizes die durchschnittlichen Brechungsindizes im Wellenlängenbereich von 800 nm bis 3 µm sind,
und wobei vorzugsweise die feste Phase der ersten und der zweiten Schicht im Wesentlichen aus dem gleichen Material wie das Massenmaterial des Substrats besteht, und wobei das Substrat ausgewählt ist aus den Substraten von Natriumkalkquarzglas, Aluminosilikatglas und Borsilikatglas.

11. Verwendung einer Doppelschicht innerhalb eines Substrats zur Verminderung des Infrarotreferenzreflexionsvermögens des Substrats nach Anspruch 10, wobei
a. die erste Schicht eine Dicke im Bereich von 10 bis 120 nm hat;
b. die poröse zweite Schicht eine Dicke im Bereich von 110 bis 400 nm und eine Porendichte im Bereich von 40 % bis 80 % hat.

12. Optische Anordnung zur Steuerung von Infrarotlicht im Bereich zwischen 800 nm und 3 µm, umfassend ein ionenimplantiertes Substrat zum Übertragen von Infrarotlicht im Infrarotlichtbereich zwischen 800 nm und 3 µm und eine infrarotempfindliche optische Komponente und/oder eine Infrarotlichtquelle, wobei
a. die implantierten Ionen eine Mischung aus einfach geladenen und mehrfach geladenen Ionen ausgewählt aus einem oder mehreren der Ionen von N, H, O, He, Ne, Ar und Kr sind, und
b. in dem Substrat mit einer Dosis zwischen 10¹⁶ Ionen/cm² und 2 × 10¹⁷ Ionen/cm² und einer Beschleunigungsspannung AV zwischen 5,5 kV und 450 kV implantiert werden,
und wobei das Substrat ausgewählt ist aus den Substraten von Natriumkalkquarzglas, Aluminosilikatglas und Borsilikatglas.

13. Optische Anordnung zum Steuern von Infrarotlicht im Bereich zwischen 800 nm und 3 µm, umfassend ein Substrat zum Übertragen von Infrarotlicht im Infrarotlichtbereich zwischen 800 nm und 3 µm und eine infrarotempfindliche optische Komponente und/oder eine Infrarotlichtquelle, wobei das Substrat zum Übertragen von Infrarotlicht eine Doppelschicht umfasst, wobei die Doppelschicht, ausgehend von der Substratoberfläche und in Richtung des Kerns des Substrats gehend, eine erste Schicht mit einem Brechungsindex n₁, wobei 0,95 × n_{b} ≤ n₁ ≤ 1,05 × n_{b}, wobei n_{b} der Brechungsindex des Massensubstrats ist, und eine zweite Schicht umfasst, die eine poröse Schicht ist, mit einem Brechungsindex n₂, wobei n₂ < n_{b}, wobei die jeweiligen Brechungsindizes die durchschnittlichen Brechungsindizes im Wellenlängenbereich von 800 nm bis 3 µm sind, und wobei das Referenzreflexionsvermögen des Substrats ein Minimum bei einer Wellenlänge λₘᵢₙ aufweist, wobei 800 nm ≤ λₘᵢₙ ≤ 3 µm, und wobei das Referenzreflexionsvermögen des Substrats bei einer Wellenlänge λ₋₅₀₀ höchstens 13 % beträgt, wobei λ₋₅₀₀ = λₘᵢₙ - 500 nm, und wobei das Substrat ausgewählt ist aus den Substraten von Natriumkalkquarzglas, Aluminosilikatglas und Borsilikatglas.

14. Optische Anordnung nach Anspruch 13, wobei die erste Schicht eine Dicke im Bereich von 10 bis 120 nm hat, und die poröse zweite Schicht eine Dicke im Bereich von 110 bis 400 nm und eine Porendichte im Bereich von 40 % bis 80 % hat.

15. Optische Anordnung nach einem der Ansprüche 12 bis 14, umfassend eine Infrarotlichtquelle, wobei die Infrarotlichtquelle ein Infrarotlaser ist, der bei einer Wellenlänge λ_{L} emittiert, und wobei das Referenzreflexionsvermögen des Substrats bei einer Wellenlänge λₘᵢₙ ein Minimum aufweist, wobei 0,95 λ_{L} ≤ λₘᵢₙ ≤ 1,05 λ_{L} ist.

## Revendications

1. Utilisation d'ions implantés pour réduire la réflectance infrarouge dans la plage de longueurs d'onde comprise entre 800 nm et 3 µm d'un substrat destiné à transmettre le rayonnement infrarouge, dans laquelle
a. les ions sont choisis à partir d'un mélange d'ions monochargés et multichargés parmi les ions de N, O, He, Ne, Ar et Kr ; et
b. sont implantés dans le substrat avec un dosage compris entre 10¹⁶ ions/cm² et 2×10¹⁷ ions/cm², et une tension d'accélération AV comprise entre 5,5 kV et 450 kV, et
dans laquelle le substrat est choisi parmi les substrats de verre silicosodocalcique, de verre d'aluminosilicate et de verre de borosilicate.

2. Utilisation d'ions implantés pour réduire la réflectance infrarouge d'un substrat destiné à transmettre le rayonnement infrarouge selon la revendication 1, dans laquelle les ions sont implantés dans le substrat avec un dosage compris entre 10¹⁶ ions/cm² et 1,5×10¹⁷ ions/cm², de préférence entre 10¹⁶ ions/cm² et 9,5×10¹⁶ ions/cm².

3. Utilisation d'ions implantés pour réduire la réflectance infrarouge d'un substrat destiné à transmettre le rayonnement infrarouge selon la revendication 1, dans laquelle le substrat est un substrat de verre sodocalcique comprenant une teneur, exprimée comme le pourcentage de poids total de verre, de :
a. fer total (exprimé en Fe₂O₃) 0,002 à 0,06 %, et
b. Cr₂O₃ 0,0001 à 0,06 %.

4. Utilisation d'ions implantés pour réduire la réflectance infrarouge d'un substrat destiné à transmettre le rayonnement infrarouge selon une quelconque revendication précédente, dans laquelle le substrat est un substrat optique plan ou une lentille.

5. Utilisation d'ions implantés pour réduire la réflectance infrarouge d'un substrat destiné à transmettre le rayonnement infrarouge selon une quelconque revendication précédente, dans laquelle la réflectance de référence moyenne du substrat dans la plage de longueurs d'onde comprise entre 800 nm et 3 µm est réduite d'au moins 1 %, de préférence d'au moins 2 %, mieux encore d'au moins 3 %.

6. Utilisation d'ions implantés pour réduire la réflectance infrarouge d'un substrat destiné à transmettre le rayonnement infrarouge selon une quelconque revendication précédente, dans laquelle la réflectance de référence du substrat présente un minimum, à une longueur d'onde λₘᵢₙ, avec 800 nm ≤ λₘᵢₙ ≤ 3 µm.

7. Utilisation d'ions implantés pour réduire la réflectance infrarouge d'un substrat destiné à transmettre le rayonnement infrarouge selon une quelconque revendication précédente, dans laquelle la réflectance de référence du substrat à une longueur d'onde λ₋₅₀₀ est de 13 % maximum, avec λ₋₅₀₀ = λₘᵢₙ - 500 nm.

8. Utilisation d'ions implantés pour réduire la réflectance infrarouge d'un substrat destiné à transmettre le rayonnement infrarouge selon une quelconque revendication précédente, dans laquelle la réflectance de référence du substrat dans la plage de longueurs d'onde de la lumière visible est de 13 % maximum.

9. Utilisation selon une quelconque revendication précédente dans laquelle
a. le rapport AV/Zₐᵥᵣ entre la tension d'accélération AV et le poids atomique standard moyen Zₐᵥᵣ des ions est compris dans la plage de 0,0029×λₘᵢₙ×kV/nm-1, 25 kV à 0,0026×λₘᵢₙ×kV/nm + 0, 68 kV, λₘᵢₙ étant la longueur d'onde du minimum de la réflectance de référence dans la plage de longueurs d'onde infrarouge de 800 nm à 3 µm.

10. Utilisation d'une bicouche à l'intérieur d'un substrat pour réduire la réflectance infrarouge de référence du substrat, dans laquelle
a. la bicouche comprend, en partant de la surface du substrat et en allant vers le coeur du substrat,
i. une première couche ayant un indice de réfraction n₁ où 0,95×n_{b} ≤ n₁ ≤ 1,05×n_{b}, n_{b} étant l'indice de réfraction du substrat massif, et
ii. une deuxième couche, qui est une couche poreuse, ayant un indice de réfraction n₂, où n₂ < n_{b},
les indices de réfraction respectifs étant les indices de réfraction moyens dans la plage de longueurs d'onde de 800 nm à 3 µm,
et dans laquelle, de préférence, la phase solide des première et deuxième couches consiste essentiellement en le même matériau que le matériau massif du substrat, et dans laquelle le substrat est choisi parmi les substrats de verre silicosodocalcique, de verre d'aluminosilicate et de verre de borosilicate.

11. Utilisation d'une bicouche à l'intérieur d'un substrat pour réduire la réflectance infrarouge de référence du substrat selon la revendication 10, dans laquelle
a. la première couche a une épaisseur dans la plage de 10 à 120 nm,
b. la deuxième couche poreuse a une épaisseur dans la plage de 110 à 400 nm et une densité de pores dans la plage de 40 % à 80 %.

12. Ensemble optique destiné à contrôler le rayonnement infrarouge dans la plage comprise entre 800 nm et 3 µm comprenant un substrat à ions implantés destiné à transmettre le rayonnement infrarouge dans la plage du rayonnement infrarouge entre 800 nm et 3 µm et un composant optique sensible aux infrarouges et/ou une source de rayonnement infrarouge, dans lequel
a. les ions implantés sont un mélange d'ions monochargés et multichargés, choisis à partir d'un ou plusieurs des ions de N, O, He, Ne, Ar et Kr ; et
b. sont implantés dans le substrat avec un dosage compris entre 10¹⁶ ions/cm² et 2×10¹⁷ ions/cm², et une tension d'accélération AV comprise entre 5,5 kV et 450 kV,
et dans lequel le substrat est choisi parmi les substrats de verre silicosodocalcique, de verre d'aluminosilicate et de verre de borosilicate.

13. Ensemble optique destiné à contrôler le rayonnement infrarouge dans la plage comprise entre 800 nm et 3 µm comprenant un substrat destiné à transmettre le rayonnement infrarouge dans la plage du rayonnement infrarouge entre 800 nm et 3 µm et un composant optique sensible aux infrarouges et/ou une source de rayonnement infrarouge, dans lequel le substrat destiné à transmettre le rayonnement infrarouge comprend une bicouche, la bicouche comprenant, en partant de la surface du substrat et en allant vers le coeur du substrat, une première couche ayant un indice de réfraction n₁ où 0,95×n_{b} ≤ n₁ ≤ 1,05×n_{b}, n_{b} étant l'indice de réfraction du substrat massif, et une deuxième couche, qui est une couche poreuse, ayant un indice de réfraction n₂, où n₂ < n_{b}, les indices de réfraction respectifs étant les indices de réfraction moyens dans la plage de longueurs d'onde de 800 nm à 3 µm, et dans lequel la réflectance de référence du substrat présente un minimum, à une longueur d'onde λₘᵢₙ, avec 800 nm ≤ λₘᵢₙ ≤ 3 µm et dans lequel la réflectance de référence du substrat à une longueur d'onde λ₋₅₀₀ est de 13 % maximum, avec λ₋₅₀₀ = λₘᵢₙ - 500 nm, et dans lequel le substrat est choisi parmi les substrats de verre silicosodocalcique, de verre d'aluminosilicate et de verre de borosilicate.

14. Ensemble optique selon la revendication 13 dans lequel la première couche a une épaisseur dans la plage de 10 à 120 nm, et la deuxième couche poreuse a une épaisseur dans la plage de 110 à 400 nm et une densité de pores dans la plage de 40 % à 80 %.

15. Ensemble optique selon l'une quelconque des revendications 12 à 14 comprenant une source de rayonnement infrarouge, dans lequel la source de rayonnement infrarouge est un laser infrarouge émettant à une longueur d'onde λ_{L} et dans lequel la réflectance de référence du substrat présente un minimum, à une longueur d'onde λₘᵢₙ, avec 0,95λ_{L} ≤ λₘᵢₙ ≤ 1,05λ_{L}.
